# EUROPEAN PATENT APPLICATION

(11) **EP 4 465 328 A1**
(43) Date of publication of application: **20.11.2024**
(21) Application number: 23220072.5
(22) Date of filing: 22.12.2023
(51) Int. Cl.: H01H 47/02, H01H 47/22

(54) **CONTROL METHOD FOR RELAY**

(30) Priority: 17.05.2023 CN 202310573077
(71) Applicant: Sungrow Power Supply Co., Ltd., Hefei, Anhui 230088 (CN)
(72) Inventor: YANG, Zongjun, Hefei, Anhui (CN); YU, Yanfei, Hefei, Anhui (CN)
(74) Representative: Zacco Norway AS

(57) **Abstract**

A control method applied to a relay circuit is provided. The relay circuit includes a controller, a relay, a controllable switch, and a power supply. The controllable switch is connected in series with a coil of the relay. The power supply is configured to supply power to the coil of the relay. The controllable switch is controlled by the controller. The method includes: receiving an operating parameter of the relay by the controller; and adjusting a driving force applied to the relay, based on the operating parameter by the controller, to reduce a sum of a conduction loss and a driving loss of the relay, thereby improving the efficiency of the relay.

## Description

### FIELD

The present application relates to the technical field of power electronics, and in particular to a control method for a relay.

### BACKGROUND

A relay is a controllable switch that controls a strong electric signal based on a weak electric signal. The relay can reliably disconnect a circuit when opening its contact, and can connect the circuit when closing the contact.

At present, the driving loss of the relay is generally reduced in order to improve efficiency of the relay. However, reducing the driving loss only does not significantly improve the efficiency of a power relay. Consequently, the power relay is still less efficient.

### SUMMARY

A control method for a relay is provided according to embodiments of the present application, to improve the efficiency of the relay. The technical solutions are as follows.

The control method is applied to a relay circuit, which includes a controller, a relay, a controllable switch, and a power supply. The controllable switch is connected in series with a coil of the relay. The power supply is configured to supply power to the coil of the relay. The controllable switch is controlled by the controller. The method includes: receiving an operating parameter of the relay by the controller; and adjusting a driving force applied to the relay, based on the operating parameter by the controller, to reduce a total loss of the relay. The total loss of the relay is a sum of a conduction loss and a driving loss of the relay.

In some embodiments, the relay circuit further includes a parameter collection device for acquiring the operating parameter. The parameter collection device is connected to the controller. The operating parameter of the relay includes at least an ambient temperature at a contact of the relay or a current flowing through the contact of the relay.

In some embodiments, the adjusting the driving force applied to the relay includes: increasing the driving force applied to the relay when the current flowing through the contact or the ambient temperature at the contact increases, to reduce the total loss of the relay by reducing the conduction loss of the relay; and decreasing the driving force applied to the relay when the current flowing through the contact or the ambient temperature at the contact decreases, to reduce the total loss of the relay by reducing the driving loss of the relay.

In some embodiments, the adjusting the driving force applied to the relay includes: controlling a duty cycle of a drive signal for driving the controllable switch using pulse width modulation, based on the operating parameter of the relay, to adjust the driving force applied to the relay.

In some embodiments, the controlling the duty cycle of the drive signal includes: controlling the duty cycle of the drive signal based on a value of the operating parameter of the relay, to adjust the driving force applied to the relay.

In some embodiments, the operating parameter is the current flowing through the contact of the relay, and the controlling the duty cycle of the drive signal includes: adjusting the duty cycle of the drive signal based on a waveform of the current flowing through the contact of the relay, to match a waveform of a current or voltage of the coil of the relay to the waveform of the current flowing through the contact of the relay.

In some embodiments, the controlling of the duty cycle of the drive signal includes: comparing the operating parameter with at least one threshold; setting the drive signal to a first duty cycle, when the operating parameter of the relay is greater than the threshold; and setting the drive signal to a second duty cycle, when the operating parameter of the relay is less than the threshold. The first duty cycle is greater than the second duty cycle, and the driving force at the first duty cycle is strong by comparison with the second duty cycle.

In some embodiments, the controlling the duty cycle of the drive signal based on the value of the operating parameter includes: adjusting the duty cycle of the drive signal to increase a current or voltage of the coil of the relay, in response to an increase in the operating parameter; and adjusting the duty cycle of the drive signal to decrease the current or voltage of the coil of the relay, in response to a decrease in the operating parameter.

In some embodiments, the adjusting the duty cycle of the drive signal to increase the current or voltage of the coil of the relay includes: adjusting the duty cycle of the drive signal to increase the current or voltage of the coil of the relay linearly, in response to the increase in the operating parameter. The adjusting the duty cycle of the drive signal to decrease the current or voltage of the coil of the relay includes: adjusting the duty cycle of the drive signal to decrease the current or voltage of the coil of the relay linearly in response to the decrease in the operating parameter.

In some embodiments, the power supply is an adjustable power supply controlled by the controller, and the adjusting the driving force applied to the relay includes: changing a voltage of the adjustable power supply based on the operating parameter, to adjust the driving force applied to the relay.

In some embodiments, the changing the voltage of the adjustable power supply based on the operating parameter includes: increasing the voltage of the adjustable power supply to strengthen the driving force applied to the relay, in response to an increase in the operating parameter; and decreasing the voltage of the adjustable power supply to weaken the driving force applied to the relay, in response to a decrease in the operating parameter.

In some embodiments, the adjusting the driving force applied to the relay includes: regulating the driving force applied to the relay within a preset range. An upper limit of the preset range does not exceed an upper limit allowed by the relay. A lower limit of the preset range is not less than a lower limit sufficient for contacts of the relay attached.

With the control method according to the embodiments of the present application, at least one of the controllable switch and the adjustable power supply is controlled based on the operating parameter of the relay to decrease the driving force applied to the relay, for the purpose of reducing the sum of the conduction loss and the driving loss of the relay. Therefore, the efficiency of the power relay can be significantly improved. Accordingly, the technical problem that the power relay is less efficient due to failure to take the conduction loss of the relay into account can be solved.

Undoubtedly, a product implementing the present application does not necessitate all the above-mentioned advantages at the same time.

### BRIEF DESCRIPTION OF THE DRAWINGS

In order to explain the embodiments of the present application or the technical solutions in the conventional technology more clearly, the drawings to be used in the description of the embodiments or the conventional technology will be briefly introduced below. Obviously, the drawings in the following description illustrate only some embodiments of the present application. For those of ordinary skill in the art, other drawings can be obtained based on these drawings without creative effort.
Figure 1 is a schematic diagram illustrating a relay circuit according to an embodiment of the present application;
Figure 2 is a flow chart illustrating a control method for a relay according to an embodiment of the present application;
Figure 3 is a schematic diagram illustrating a relationship between a driving force and a contact impedance according to an embodiment of the present application;
Figure 4 is a flow chart illustrating control on the driving force applied to the relay according to an embodiment of the present application;
Figure 5 is a flow chart illustrating control on a duty cycle of a drive signal applied to a controllable switch according to an embodiment of the present application;
Figure 6 is a schematic diagram illustrating pulses according to an embodiment of the present application;
Figure 7 is a flow chart illustrating the control on the duty cycle of the drive signal applied to the controllable switch according to another embodiment of the present application;
Figure 8 is a schematic diagram illustrating pulses according to another embodiment of the present application;
Figure 9 is a schematic diagram illustrating a driving waveform according to an embodiment of the present application;
Figure 10 is a structural diagram illustrating the relay circuit according to an embodiment of the present application;
Figure 11 is a structural diagram illustrating the relay circuit according to another embodiment of the present application;
Figure 12 is a schematic diagram illustrating the relay circuit according to another embodiment of the present application; and
Figure 13 is a schematic diagram illustrating the relay circuit according to another embodiment of the present application.

### DETAILED DESCRIPTION

The technical solutions in the embodiments of the present application will be clearly and completely described below with reference to the accompanying drawings in the embodiments of the present application. Obviously, the described embodiments are only some rather than all the embodiments of the present application. Based on the embodiments of the present application, all other embodiments obtained by those of ordinary skill in the art without creative effort fall within the scope of protection of the present application.

A relay suffers power loss including the driving loss and the conduction loss. The driving loss is the energy consumed by energizing the coil, and is expressed as P1=I₁²R₁, where P₁ is the driving loss, I₁ is a driving current, and R₁ is the impedance of the coil of the relay. The conduction loss is the energy consumed by energizing a main circuit, and is expressed as P₂=I₂²R₂, where P₂ is the conduction loss, I₂ is a current through the main circuit, and R₂ is the on-state impedance.

A power relay connects the main circuit at low impedance. Since the current through the main circuit is large, the conduction loss is much greater than the driving loss, resulting in failure to significantly improve efficiency of the relay by reducing only the driving loss and ignoring the conduction loss. Consequently, the main circuit is still less efficient.

Based on the above, a control method for the relay is provided according to the present application. The control method is applied to a relay circuit including a controller, a relay, a controllable switch, and a power supply. The controllable switch is connected in series with a coil of the relay. The power supply is configured to supply power to the coil of the relay. The controllable switch is controlled by the controller.

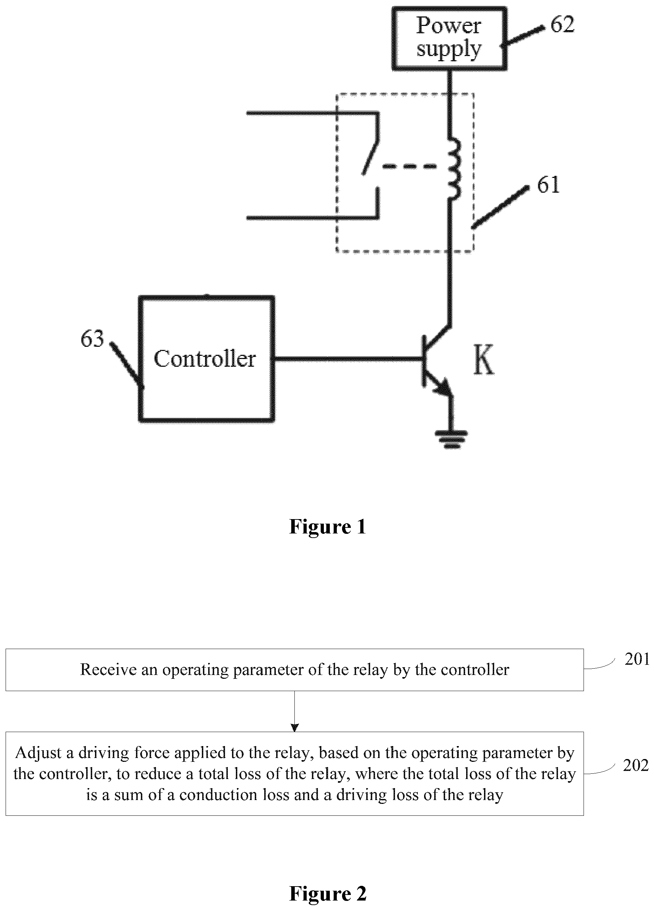

Figure 1 is a structural diagram illustrating the relay circuit. As shown in Figure 1, one end of a coil of a relay 61 is connected to a power supply 62, and the other end of the coil is connected to a controllable switch K. The controllable switch K is controlled by a controller 63. The controller sends a PWM (Pulse Width Modulation) signal to the controllable switch, and the controllable switch is closed or open in response to the PWM signal. The controller further sends a switching command signal to the controllable switch, and the controllable switch is closed in response to an on-state command or opened in response to an off-state command. The controller is an MCU (Microcontroller Unit), for example.

As shown in Figure 2, the method includes the following steps 201 to 202.

In 201, the controller receives an operating parameter of a contact of the relay.

In 202, the controller adjusts a driving force applied to the relay based on the operating parameter of the contact of the relay, to reduce a total loss of the relay. The total loss of the relay is sum of the conduction loss and the driving loss of the relay.

The contact of the relay is usually a metal dome, and the mechanical contact between two contacts of the relay relies on magnetic attraction of an electromagnet. The greater the magnetic attraction is, the more tightly the contacts are attached to each other. Accordingly, the contact area between the two contacts increases, and the contact impedance between the contacts decreases, thereby reducing the impedance of the main circuit. As the magnetic attraction of the electromagnet becomes weaker, the contacts loosely attached to each other, and the contact area between the two contacts decreases. As a result, the contact impedance between the contacts increases, thereby increasing the impedance of the main circuit.

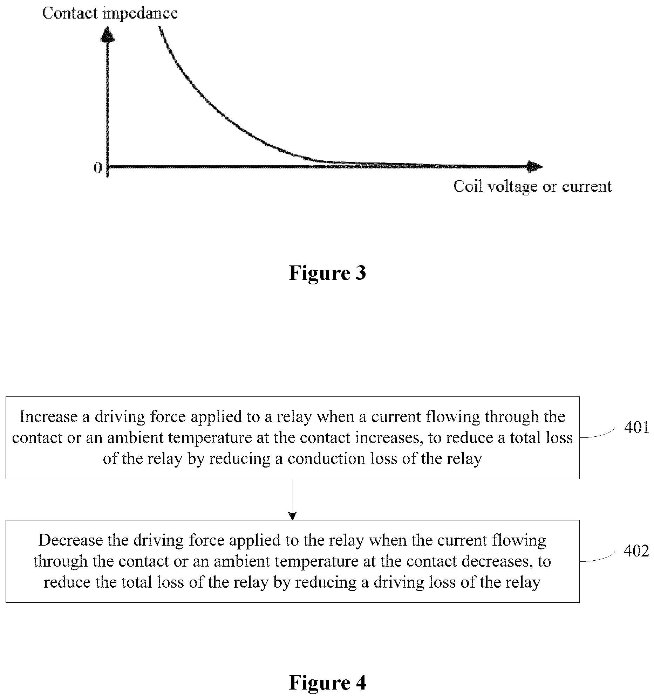

Figure 3 shows the relationship between the driving force and the contact impedance. The voltage or current of the coil is directly proportional to the driving force applied to the relay. The larger the coil voltage or current is, the smaller the contact impedance is. The smaller the voltage or current of the coil is, the larger the contact impedance is. It can be seen from Figure 3 that as the driving force applied to the relay increases, the contact impedance of the relay decreases. According to the equation of the conduction loss, the on-state impedance decreases as the contact impedance decreases. In the case that the current through the main circuit is large, reducing the contact impedance has a significant effect on reducing the conduction loss.

In order to improve the efficiency of the relay, i.e., reduce the total loss of the relay, the driving loss or conduction loss is to be reduced. For reducing the driving loss, a lower driving voltage is usually applied to the coil to reduce the coil loss, or the pulse width modulation is applied to weaken the driving force. Reducing the driving force inevitably increases the contact impedance, resulting in increased conduction loss. For situations where the conduction loss is greater than the driving loss, for example, a power relay, the current through the main circuit is large, and thus the conduction loss is much greater than the driving loss. In this case, the contact impedance of the relay is reduced by increasing the driving force applied to the relay. That is, the total loss of the relay is reduced by reducing the conduction loss. When the current through the main circuit is small, the total loss of the relay is reduced by reducing the driving loss. Based on this, in order to exert a significant effect on the improvement in the efficiency of the relay, both the driving loss and the conduction loss are taken into account to reduce the total loss of the relay according to the present application.

The basis for adjusting the driving force applied to the relay is the operating parameter of the contact of the relay. The contact of the relay is connected to the main circuit. That is, the contact of the relay is connected to the load circuit. Therefore, the operating parameter reflects operating data about the main circuit of the relay. The driving force applied to the relay is adjusted dynamically based on the operating data about the main circuit. The conduction loss is reduced when the current through the main circuit is large, and the driving loss is reduced when the current through the main circuit is small, thereby significantly improving the overall efficiency of the relay.

In some embodiments, the driving force applied to the relay is directly proportional to the operating parameter.

An increase in the operating parameter indicates that the current through the main circuit is relatively large. In this case, the efficiency of the relay is improved by reducing the conduction loss. The driving force applied to the relay is increased, the contact impedance of the relay is reduced, and then the conduction loss is reduced. When the current through the main circuit is excessively large, reducing the conduction loss has a significant effect on the improvement in the overall efficiency of the relay.

A decrease in the operating parameter indicates that the current through the main circuit is small. The driving force applied to the relay is reduced, and then the driving loss is reduced. When the current through the main circuit is small, the driving loss is taken into account to improve the overall efficiency of the relay.

In some embodiments, the operating parameter of the contact of the relay is an ambient temperature at the contact of the relay or a current flowing through the contact of the relay.

In some embodiments, the current flowing through the contact of the relay is the current through the circuit to which the contact of the relay is connected, that is, the load current. The current through the circuit to which the contact of the relay is connected is an instantaneous current or average current.

The current flowing through the contact of the relay reflects the intensity of the current through the main circuit of the relay. An increase in the current flowing through the contact of the relay indicates that the current through the main circuit of the relay is increased. When the current flowing through the contact of the relay increases, the driving force applied to the relay is increased to reduce the contact impedance of the relay, thereby reducing the conduction loss. A decrease in the current flowing through the contact of the relay indicates that the current through the main circuit of the relay is reduced. When the current flowing through the contact of the relay decreases, the driving force applied to the relay is reduced, and thus the driving loss is reduced.

The ambient temperature at the contact of the relay reflects the amount of the conduction loss of the relay. The higher the ambient temperature is, the greater the conduction loss of the relay is, i.e., the larger the current through the main circuit is. In this case, the driving force applied to the relay is increased to reduce the contact impedance of the relay, thereby reducing the conduction loss. The lower the ambient temperature is, the smaller the conduction loss is, i.e., the smaller the current through the main circuit is. In this case, the driving loss is reduced, i.e., the driving force applied to the relay is weakened, thereby reducing the driving loss. Therefore, the overall efficiency of the relay can be significantly improved.

The relay circuit further includes a parameter collection device for acquiring the operating parameter. The parameter collection device is connected to the controller.

In some embodiments, the parameter collection device includes a current sensing module or a temperature sensing module. The current sensing module is configured to sense the current flowing through the contact of the relay. The temperature sensing module is configured to sense the ambient temperature at the contact of the relay. The current sensing module is a current sensor, and the temperature sensing module is a temperature sensor, for example.

The current sensor senses the current flowing through the contact of the relay, i.e., the load current, that is, the current through the main circuit. If there is a load current sampling module in the system, no current sensing module is provided additionally. Instead, the load current sampling module directly senses the current flowing through the contact of the relay and transmits the sensed current to the controller.

In some embodiments, the sensed current flowing through the contact of the relay is filtered, and therefore a filter module is provided. An input end of the filter module is connected to the current sensing module, and an output end of the filter module is connected to the controller.

In some embodiments, as shown in Figure 4, the driving force applied to the relay is adjusted based on the operating parameter by the following steps 401 to 402.

In 401, the driving force applied to the relay is strengthened to reduce the total loss of the relay by reducing the conduction loss of the relay, when the current flowing through the contact of the relay or the ambient temperature at the contact increases.

In 402, the driving force applied to the relay is weakened to reduce the total loss of the relay by reducing the driving loss of the relay, when the current flowing through the contact of the relay or the ambient temperature at the contact decreases.

As the current flowing through the contact of the relay increases, the conduction loss of the relay increases. In order to improve the efficiency of the relay, the driving force applied to the relay is strengthened to reduce the contact impedance of the relay, and thence to reduce the conduction loss, thereby reducing the total loss of the relay.

When the current flowing through the contact of the relay decreases, the conduction loss of the relay is relatively small. In order to improve the efficiency of the relay, the driving force applied to the relay is reduced. As the driving force applied to the relay decreases, the driving loss of the relay decreases, and thus the total loss of the relay is reduced, thereby improving the overall efficiency of the relay.

When the ambient temperature at the contact increases, the conduction loss of the relay is relatively large. In order to reduce the conduction loss of the relay, the driving force applied to the relay is increased to reduce the contact impedance of the relay, and thence to reduce the total loss of the relay, thereby improving the efficiency of the relay.

When the ambient temperature at the contact decreases, the conduction loss of the relay is relatively small. In order to improve the efficiency of the relay, the driving force applied to the relay is reduced. As the driving force applied to the relay decreases, the driving loss of the relay decreases, and thus the total loss of the relay is reduced, thereby improving the overall efficiency of the relay.

In some embodiments, the driving force applied to the relay is adjusted based on the operating parameter of the relay as follows. The controllable switch is driven using the pulse width modulation. A duty cycle of a drive signal applied to the controllable switch is controlled based on the operating parameter of the relay, to adjust the driving force applied to the relay.

The driving force applied to the relay changes by driving the controllable switch using the pulse width modulation.

The greater the duty cycle of the drive signal is, the longer the controllable switch is on in one cycle, the greater the current or voltage of the coil of the relay is, and the stronger the driving force applied to the relay is. The smaller the duty cycle of the drive signal is, the shorter the controllable switch is on in one cycle, the smaller the current or voltage of the coil of the relay is, and the weaker the driving force applied to the relay is.

Based on the operating parameter of the relay, the driving force applied to the relay is adjusted by changing the duty cycle of the drive signal applied to the controllable switch. The controller receives the operating parameter of the relay, and adjusts the duty cycle of the drive signal applied to the controllable switch based on the received operating parameter of the relay. The operating parameter of the relay is the current flowing through the contact of the relay or the ambient temperature at the contact of the relay.

In some embodiments, the duty cycle of the drive signal applied to the controllable switch is controlled based on the operating parameter of the relay to adjust the driving force applied to the relay as follows. The duty cycle of the drive signal applied to the controllable switch is set based on a value of the operating parameter of the relay, to adjust the driving force applied to the relay.

When the operating parameter of the relay is the current flowing through the contact of the relay, the greater the current is, the greater the driving force applied to the relay is. In this case, the duty cycle of the drive signal applied to the controllable switch is increased to increase the current or voltage of the coil of the relay. Thus, the driving force applied to the relay is increased, the contact impedance of the relay is reduced, and then the conduction loss of the relay is reduced. The smaller the current is, the smaller the driving force applied to the relay is. In this case, the duty cycle of the drive signal applied to the controllable switch is reduced to reduce the current or voltage of the coil of the relay. Thus, the driving force applied to the relay is reduced, and then the driving loss of the relay is reduced.

When the operating parameter of the relay is the ambient temperature at the contact of the relay, the greater the ambient temperature is, the greater the driving force applied to the relay is. In this case, the duty cycle applied to the drive signal of the controllable switch is increased to increase the current or voltage of the coil of the relay. Thus, the driving force applied to the relay is increased, the contact impedance of the relay is reduced, and therefore the conduction loss of the relay is reduced. The smaller the ambient temperature is, the smaller the driving force applied to the relay is. In this case, the duty cycle of the drive signal applied to the controllable switch is reduced to reduce the current or voltage of the coil of the relay. Thus, the driving force applied to the relay is reduced, and then the driving loss of the relay is reduced.

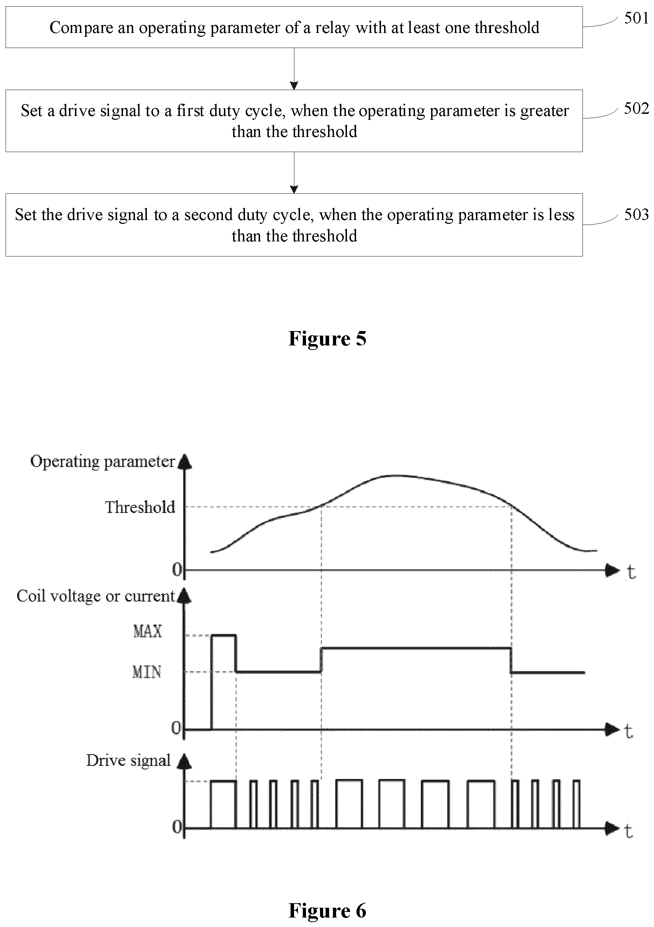

In some embodiments, as shown in Figure 5, the duty cycle of the drive signal applied to the controllable switch is controlled based on the operating parameter of the relay, by the following steps 501 to 502.

In 501, the operating parameter of the relay is compared with at least one threshold.

In 502, the drive signal applied to the controllable switch is set to a first duty cycle, when the operating parameter of the relay is greater than the threshold.

In 503, the drive signal applied to the controllable switch is set to a second duty cycle, when the operating parameter of the relay is less than the threshold.

The first duty cycle is greater than the second duty cycle. The driving force applied to the relay when the duty cycle of the drive signal applied to the controllable switch is the first duty cycle is greater than the driving force applied to the relay when the duty cycle of the drive signal applied to the controllable switch is the second duty cycle.

As shown in Figure 6, there is only one threshold. When the operating parameter of the relay is greater than the threshold, the duty cycle of the drive signal applied to the controllable switch is large, the current or voltage of the coil of the relay is increased, and therefore the driving force applied to the relay is increased. Thus, the contact impedance of the relay is reduced, and therefore the conduction loss of the relay is reduced. When the operating parameter of the relay is less than the threshold, the duty cycle of the drive signal that applied to the controllable switch is small, the current or voltage of the coil of the relay is reduced, and therefore the driving force applied to the relay is reduced, thereby reducing the driving loss of the relay. The abscissa in Figure 6 represents time t, and the operating parameter of the relay is the current flowing through the contact of the relay or the ambient temperature at the contact of the relay.

The comparison between a single threshold and the operating parameter is suitable for situations where the load changes slightly. In practical applications, multiple thresholds are set for hierarchical control. That is, the duty cycle of the drive signal varies with multiples thresholds. For example, there are two thresholds, namely a first threshold and a second threshold. The first threshold is smaller than the second threshold. When the operating parameter of the relay is smaller than the first threshold, the drive signal applied to the controllable switch is set to a third duty cycle. When the operating parameter of the relay is greater than the first threshold and less than the second threshold, the drive signal applied to the controllable switch is set to a fourth duty cycle. When the operating parameter of the relay is greater than the second threshold, the drive signal applied to the controllable switch is set to a fifth duty cycle. The fifth duty cycle is greater than the fourth duty cycle which is greater than the third duty cycle. The greater the duty cycle is, the greater the current or voltage of the coil of the relay is, and the greater the driving force applied to the relay is.

**Table 1 Loss of the relay under various conditions**

| | A | B | C | D | E | F |
|---|---|---|---|---|---|---|
| I₁ | 0.5 | 0.5 | 0.6 | 0.4 | 0.5 | 0.5 |
| R₁ | 40 | 40 | 40 | 40 | 40 | 40 |
| P₁ | 10 | 10 | 14.4 | 6.4 | 10 | 10 |
| I₂ | 40 | 50 | 50 | 10 | 10 | 20 |
| R₂ | 0.01 | 0.01 | 0.00 8 | 0.01 5 | 0.01 | 0.01 |
| P₂ | 16 | 25 | 20 | 1.5 | 1 | 4 |

Table 1 shows loss of the relay under six conditions, namely, A, B, C, D, E, and F. P₁ is the driving loss in unit of W, I₁ is the driving current in unit of A, R₁ is the impedance of the coil of the relay in unit of S2, and P₁=I₁²R₁. P₂ is the conduction loss in unit of W, I₂ is the load current in unit of A, which is also the current flowing through the contact of the relay, R₂ is the on-state impedance in unit of S2, and P₂=I₂²R₂.

When the relay switches from the condition A to the condition B, that is, the load current increases from 40A to 50A with the driving force remaining unchanged, the loss increases by (25-16)=9W. The driving current is increased under the condition C. Although the driving loss increases by (14.4-10)=4.4W, the conduction loss decreases by (25-20)=5W, and therefore the total loss of the relay is decreased. One threshold is set to 50A. The conduction loss is reduced when the operating parameter is greater than 50A, and the driving loss is reduced when the operating parameter is less than 50A, so that the total loss of the relay is reduced.

On the contrary, when the relay switches from the condition F to the condition E, that is, the load current decreases from 20A to 10A with the driving force remaining unchanged, the loss is reduced by (4-1)=3W. The driving current is reduced under the condition D. Although the conduction loss increases by (1.5-1)=0.5W, the driving loss decreases by (10-6.4)=3.6W, and therefore the total loss of the relay is decreased. Another threshold is set to 10A. The conduction loss is reduced when the operating parameter is greater than 10A, and the driving loss is reduced when the operating parameter is less than 10A, so that the total loss of the relay is reduced.

It can be seen that according to the present application, the driving force is increased when the load current is large, and is reduced when the load current is small. The threshold depends on actual conditions, and therefore is not limited thereto.

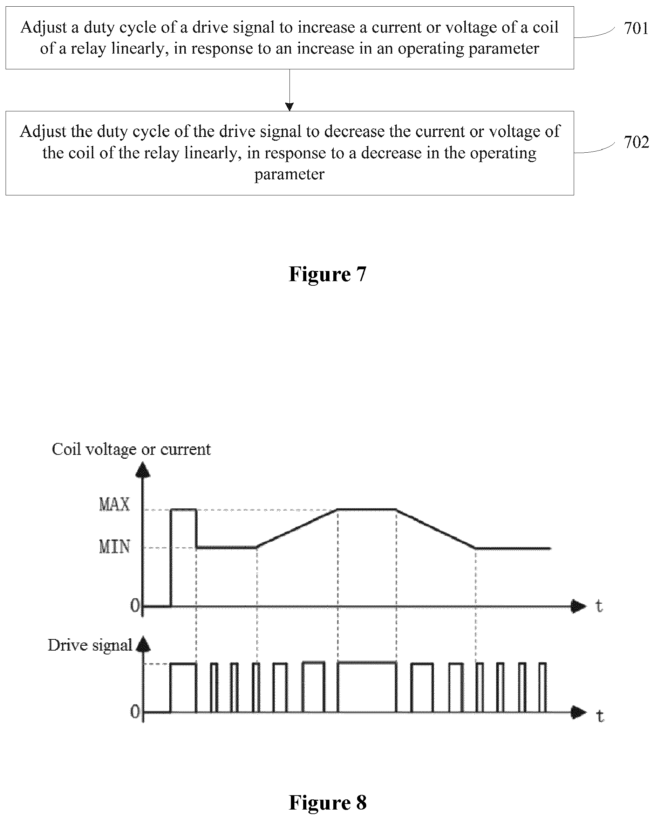

In some embodiments, as shown in Figure 7, the duty cycle of the drive signal applied to the controllable switch is set based on the value of the operating parameter of the relay by the following steps 701 to 702.

In 701, the duty cycle of the drive signal applied to the controllable switch is adjusted to increase the current or voltage of the coil of the relay, when the operating parameter of the relay increases.

In 702, the duty cycle of the drive signal applied to the controllable switch is adjusted to decrease the current or voltage of the coil of the relay, when the operating parameter of the relay decreases.

In some embodiments, the duty cycle of the drive signal applied to the controllable switch is adjusted to increase the current or voltage of the coil of the relay as follows. When the operating parameter of the relay increases, the duty cycle of the drive signal of the controllable switch is adjusted to increase the current or voltage of the coil of the relay linearly.

In some embodiments, the duty cycle of the drive signal applied to the controllable switch is adjusted to decrease the current or voltage of the coil of the relay as follows. When the operating parameter of the relay decreases, the duty cycle of the drive signal of the controllable switch is adjusted to decrease the current or voltage of the coil of the relay linearly.

The drive signal applied to the controllable switch, i.e., the PWM signal, is repeatedly adjusted based on the operating parameter. In some embodiments, the PWM signal is repeatedly adjusted based on the load current, i.e., the current flowing through the contact of the relay. By repeatedly adjusting the duty cycle of the drive signal, the current or voltage of the coil of the relay is increased or reduced linearly.

As shown in Figure 8, as the duty cycle of the drive signal applied to the controllable switch increases, the current or voltage of the coil of the relay increases linearly. As the duty cycle of the drive signal applied to the controllable switch decreases, the current or voltage of the coil of the relay decreases linearly.

In some embodiments, the driving force applied to the relay is adjusted by changing the duty cycle of the drive signal applied to the controllable switch based on the operating parameter of the relay as follows. When the operating parameter of the relay is the current flowing through the contact of the relay, the duty cycle of the drive signal applied to the controllable switch is adjusted based on a waveform of the current flowing through the contact of the relay, to match the waveform of the current or voltage of the coil of the relay to the waveform of the current flowing through the contact of the relay.

In some situations, the load varies significantly in real time, for example, a grid-connected or motor load in the renewable energies. The current waveform is a sine wave. In this case, the duty cycle of the drive signal applied to the controllable switch is adjusted to match the waveform of the current or voltage of the coil of the relay to the waveform of the current flowing through the contact of the relay. That is, the waveform of the current or voltage of the coil of the relay is identical to the waveform of the current flowing through the contact of the relay, or the waveform of the current or voltage of the coil of the relay and the waveform of the current flowing through the contact of the relay are symmetrical.

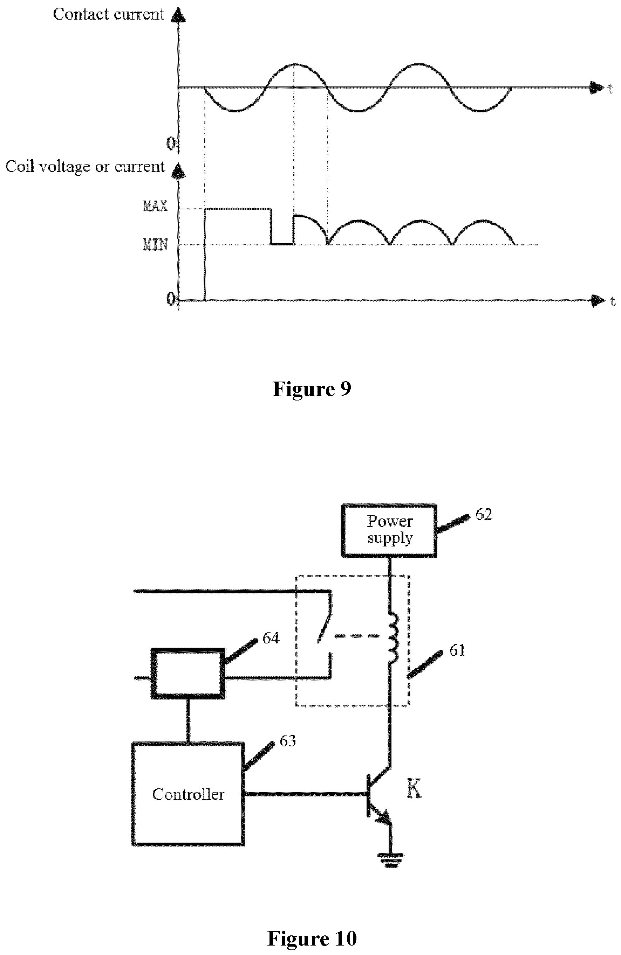

As shown in Figure 9, the contact current represents the current flowing through the contact of the relay, and the waveform of the contact current is a sine wave. In this mode, the duty cycle of the drive signal applied to the controllable switch is increased when the contact current increases, to increase the voltage or current of the coil of the relay. When the contact current reaches the peak, the current or voltage of the coil of the relay is maximum. The contacts are attached increasingly tightly by increasing the driving force applied to the relay, and therefore the contact impedance of the contact of the relay is reduced, so that the conduction loss of the relay is reduced. When the contact current decreases, the duty cycle of the drive signal applied to the controllable switch is reduced to reduce the voltage or current of the coil of the relay. The voltage or current of the coil of the relay approximates 0 in proximity to the zero-crossing of the contact current, and the loss of the main circuit is relatively small. In this case, the driving force applied to the relay is also controlled to be relatively small to reduce the driving loss.

It should be noted that, the drive signal applied to the controllable switch is such controlled that the waveform of the current or voltage of the coil of the relay is a square wave, triangle wave, sine wave, etc., depending on the load.

In some embodiments, the driving force applied to the relay is adjusted by: regulating the driving force applied to the relay to be within a preset range.

An upper limit of the preset range does not exceed an upper limit allowed by the relay, and a lower limit of the preset range is not less than a lower limit sufficient for the contacts of the relay attached.

The coil of the relay must function properly while adjusting the driving force applied to the relay. The driving force applied to the relay is increased to the upper limit by setting the duty cycle of the drive signal applied to the controllable switch to 100%. In this case, the relay works under the rated operating condition. The driving force applied to the relay is decreased to the lower limit by setting the duty cycle of the drive signal applied to the controllable switch to 70%. Undoubtedly, the duty cycle is set depending on actual situations. The duty cycle setting to 70% is only an example, and is not limited herein. When the duty cycle is set to 70%, the driving force applied to the relay is still sufficient for the contacts of the relay attached.

As shown in Figures 6, 8 and 9, when the driving force applied to the relay is maximum, the voltage or current of the coil is at the maximum MAX. When the driving force applied to the relay is minimum, the voltage or current of the coil is at the minimum MIN.

In some embodiments, the relay is started under a rated driving force before the driving force applied to the relay is adjusted based on the operating parameter of the relay. The driving force applied to the relay is not adjusted until the contacts of the relay are attached.

The relay is started by applying the rated driving force to the relay before reducing the loss of the relay. The driving force applied to the relay is adjusted based on the operating parameter of the relay only after the relay operates stably, that is, the contacts of the relay are attached.

As shown in Figures 6, 8 and 9, the relay is started under the rated driving force before the driving force applied to the relay is adjusted. In this case, the voltage or current of the coil is the maximum MAX. The driving force applied to the relay is never lower than the lower limit, i.e., the voltage or current of the coil is never lower than the minimum MIN.

In some embodiments, the driving force applied to the relay is adjusted based on the operating parameter of the relay as follows. A voltage of an adjustable power supply is adjusted based on the operating parameter of the relay, to adjust the driving force applied to the relay.

The driving force applied to the relay changes by changing the voltage of the adjustable power supply that supplies power to the coil of the relay. One end of the coil of the relay is connected to the adjustable power supply. The adjustable power supply is controlled by the controller. The controller controls the voltage of the adjustable power supply to adjust the driving force applied to the relay. In some embodiments, the adjustable power supply is a buck circuit, a flyback circuit, or the like. The other end of the coil of the relay is connected to a switch. In some embodiments, the switch is the controllable switch controlled by the controller. The switch receives the PWM signal and switches on or off in response to the PWM signal. The switch also receives the switching command signal, and is closed in response to the on-state command or opened in response to the off-state command. The controller is an MCU, for example.

Since the coil of the relay functions as a resistor when the relay operates stably. Changing the voltage of the adjustable power supply that supplies power to the coil of the relay is equivalent to changing the driving current. The greater the voltage of the adjustable power supply is, the greater the current or voltage of the coil of the relay is, the greater the driving force applied to the relay is, and the lower the contact impedance between the contacts of the relay is. In view of this, the conduction loss of the relay is reduced. The smaller the voltage of the adjustable power supply is, the smaller the current or voltage of the coil of the relay is, and the smaller the driving force applied to the relay is. In view of this, the driving loss of the relay is reduced.

The voltage of the adjustable power supply that supplies power to the coil of the relay is adjusted based on the operating parameter of the relay, so that the driving force applied to the relay is adjusted. The controller receives the operating parameter of the relay, and adjusts the voltage of the adjustable power supply based on the received operating parameter of the relay. The operating parameter of the relay is the current flowing through the contact of the relay or the ambient temperature at the contact of the relay.

In some embodiments, in order to adjust the driving force applied to the relay, the voltage of the adjustable power supply is adjusted based on the operating parameter of the relay as follows. The voltage of the adjustable power supply is increased to increase the driving force applied to the relay when the operating parameter of the relay increases. The voltage of the adjustable power supply is decreased to reduce the driving force applied to the relay when the operating parameter of the relay decreases.

In some embodiments, the operating parameter of the relay is the current flowing through the contact of the relay. The greater the current flowing through the contact of the relay is, the greater the driving force applied to the relay is. In this case, the voltage of the adjustable power supply is increased, and then the current or voltage of the coil of the relay is increased. Thus, the driving force applied to the relay is increased, the contact impedance of the relay is reduced accordingly, and therefore the conduction loss of the relay is reduced. The smaller the current flowing through the contact of the relay is, the smaller the driving force applied to the relay is. In this case, the voltage of the adjustable power supply is reduced, and the current or voltage of the coil of the relay is reduced accordingly. Thus, the driving force applied to the relay is reduced, and therefore the driving loss of the relay is reduced.

In other embodiments, the operating parameter of the relay is the ambient temperature at the contact of the relay. The greater the ambient temperature at the contact of the relay is, the greater the driving force applied to the relay is. In this case, the voltage of the adjustable power supply is increased, and the current or voltage of the coil of the relay is increased accordingly. Thus, the driving force applied to the relay is increased, the contact impedance of the relay is reduced accordingly, and therefore the conduction loss of the relay is reduced. The smaller the ambient temperature at the contact of the relay is, the smaller the driving force applied to the relay is. In this case, the voltage of the adjustable power supply is reduced, and the current or voltage of the coil of the relay is reduced accordingly. Thus, the driving force applied to the relay is reduced, and therefore the driving loss of the relay is reduced.

It should be noted that the voltage of the adjustable power supply is also controlled to be within such a range that the relay can function properly. That is, the voltage of the adjustable power supply is such adjusted that the driving force applied to the relay is always within the preset range. The upper limit of the preset range does not exceed an upper limit allowed by the relay, and the lower limit of the preset range is not less than a lower limit sufficient for the contacts of the relay attached.

In addition, the relay is started under the rated driving force before the driving force applied to the relay is adjusted. The driving force applied to the relay is not adjusted until the contacts of the relay are attached.

According to the present application, the duty cycle of the drive signal applied to the controllable switch (hereinafter referred to as the duty cycle) or the voltage of the adjustable power supply that supplies power to the coil of the relay is adjusted based on the current flowing through the contact of the relay or the ambient temperature at the contact of the relay. When the current through the contact or the ambient temperature at the contact increases, the duty cycle or the voltage of the power supply is increased, then the driving force applied to the relay is increased, and the contact impedance of the relay is reduced accordingly, therefore the conduction loss is decreased. When the current through the contact or the ambient temperature at the contact decreases, the duty cycle or the voltage of the power supply is reduced, and the driving force applied to the relay is reduced accordingly, therefore the driving loss is decreased. In this way, the overall efficiency of the relay circuit can be significantly improved.

In some embodiments, the driving force applied to the relay is adjusted by changing the duty cycle of the drive signal applied to the controllable switch based on the current flowing through the contact of the relay. As shown in Figure 10, a current sensing module 64 is added on the basis of Figure 1. The current sensing module 64 is connected in series with the contacts of the relay 61. The switch K in Figure 10 is a controllable switch controlled by the controller 63. The controllable switch K is connected in series with the coil of the relay 61. The coil is energized by the power supply 62. In some embodiments, the current sensing module 64 is a current sensor, which senses the current flowing through the contact of the relay and transmits the sensed current to the controller 63. The controller changes the duty cycle of the PWM signal applied to the controllable switch K based on the current flowing through the contact of the relay, to adjust the driving force applied to the relay. When the current sensed by the current sensing module 64 increases, the controller increases the duty cycle. Therefore, the controllable switch driven by this PWM signal is on for a long period of time, the current or voltage of the coil of the relay increases, the driving force applied to the relay increases accordingly, and therefore the conduction loss is reduced. When the current sensed by the current sensing module 64 decreases, the controller decreases the duty cycle, the controllable switch driven by this PWM signal is on for a short period of time, the current or voltage of the coil of the relay decreases, the driving force applied to the relay decreases accordingly, and therefore the driving loss is reduced.

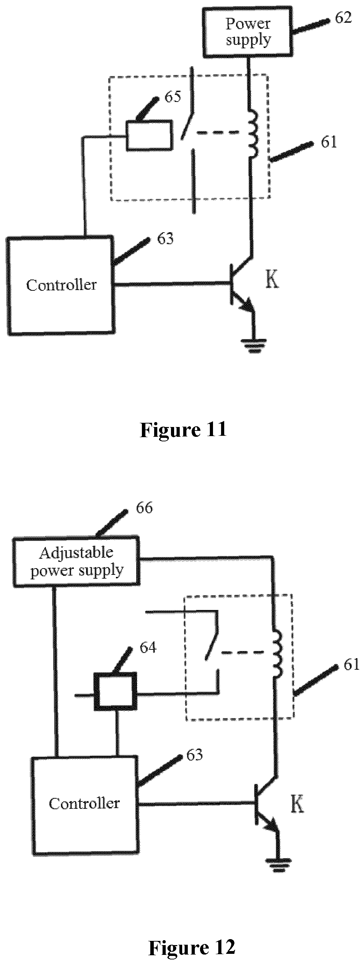

In other embodiments, the driving force applied to the relay is adjusted by changing the duty cycle of the drive signal applied to the controllable switch based on the ambient temperature at the contact of the relay. As shown in Figure 11, the current sensing module is replaced with a temperature sensing module 65 on the basis of Figure 10. The switch K in Figure 11 is a controllable switch controlled by the controller 63. The controllable switch K is connected in series with the coil of the relay 61. The coil is energized by the power supply 62. The temperature sensing module 65 is a temperature sensor, for example. The temperature sensor is a thermistor, for example, an NTC (Negative Temperature Coefficient) thermistor. The temperature sensing module 65 is located in proximity to the contact of the relay, to senses the ambient temperature at the contact of the relay 61. The temperature sensing module 65 is connected to the controller 63. The controller 63 changes the duty cycle of the PWM signal applied to the controllable switch K based on the ambient temperature at the contact of the relay, to adjust the driving force applied to the relay. An increase in temperature sensed by the temperature sensing module 65 indicates that the conduction loss of the relay increases. The controller increases the duty cycle, the controllable switch driven by this PWM signal is on for a long period of time, the current or voltage of the coil of the relay increases, the driving force applied to the relay increases accordingly, and therefore the conduction loss is reduced. When the temperature sensed by the temperature sensing module 65 decreases, the controller decreases the duty cycle, the controllable switch driven by this PWM signal is on for a short period of time, the current or voltage of the coil of the relay decreases, the driving force applied to the relay decreases accordingly, and therefore the driving loss is reduced.

In other embodiments, the driving force applied to the relay is adjusted by changing the voltage of the adjustable power supply based on the current flowing through the contact of the relay. As shown in Figure 12, the power supply is replaced with an adjustable power supply 66 on the basis of Figure 10. The adjustable power supply is a buck circuit or a flyback circuit. The adjustable power supply 66 is controlled by the controller 63. The adjustable power supply 66 supplies power to the coil of the relay 61. The controller sends a switching command to the switch K. After the switch K is closed, the current sensing module 64 transmits the sensed current flowing through the contact of the relay to the controller 63. The controller changes the voltage of the adjustable power supply 66 based on the current flowing through the contact of the relay. When the current sensed by the current sensing module 64 increases, the controller increases the voltage of the adjustable power supply 66, the current or voltage of the coil of the relay increases, the driving force applied to the relay increases accordingly, and therefore the conduction loss is reduced. When the current sensed by the current sensing module 64 decreases, the controller decreases the voltage of the adjustable power supply 66, the current or voltage of the coil of the relay decreases, the driving force applied to the relay decreases accordingly, and therefore the driving loss is reduced.

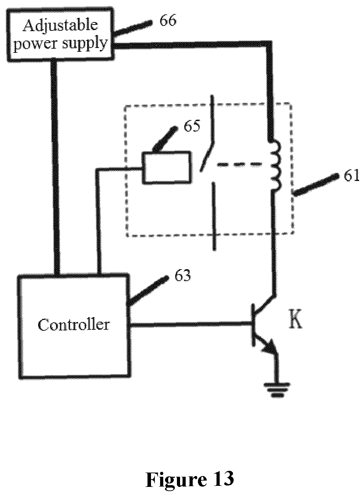

In some embodiments, the driving force applied to the relay is adjusted by changing the voltage of the adjustable power supply based on the ambient temperature at the contact of the relay. As shown in Figure 13, the power supply is replaced with an adjustable power supply 66 on the basis of Figure 11. The adjustable power supply 66 is a buck circuit or a flyback circuit. The adjustable power supply 66 is controlled by the controller 63. The adjustable power supply 66 supplies power to the coil of the relay 61. The controller sends a switching command to the switch K. After the switch K is closed, the temperature sensing module 65 transmits the sensed ambient temperature at the contact of the relay to the controller 63. The controller changes the voltage of the adjustable power supply 66 based on the ambient temperature at the contact. An increase in temperature sensed by the temperature sensing module 65 indicates that the conduction loss of the relay increases. The controller increases the voltage of the adjustable power supply 66, the current or voltage of the coil of the relay increases, the driving force applied to the relay increases accordingly, and therefore the conduction loss is reduced. When the temperature sensed by the temperature sensing module 65 decreases, the controller decreases the voltage of the adjustable power supply 66, the current or voltage of the coil of the relay decreases, the driving force applied to the relay decreases accordingly, and therefore the driving loss is reduced.

According to the present application, the driving force applied to the relay is adjusted dynamically based on the operating parameter of the relay, and therefore the contact impedance between contacts of the relay is changed. Both the driving loss and conduction loss are taken into account to reduce the total loss of the relay, thereby significantly improving the overall efficiency of the relay.

It should be noted that the relational terms such as first and second are only used herein to distinguish one entity or operation from another instead of necessitating or implying any actual relationship or order between these entities or operations. It should also be noted that the terms "comprise", "include", or any other variation thereof are intended to be non-exclusive, such that a process, method, article, or device that includes a list of elements not only includes those elements, but also includes other elements which are not expressly listed or are inherent in the process, method, article, or device. Without further limitation, an element qualified by the statement "comprises a..." does not exclude the presence of additional identical elements in the process, method, article, or device that includes the element.

The embodiments are described in a progressive manner herein. The same and similar parts between the various embodiments can be referred to each other. Each embodiment focuses on its differences from other embodiments. In particular, the system or system embodiment is basically similar to the method embodiment, and therefore is described relatively briefly. For relevant details, reference can be made to the corresponding description of the method embodiment. The system and system embodiments described above are only illustrative, in which the units described as separate components may or may not be physically separated, and the components shown as units may or may not be physical units, that is, may be located in one place, or distributed over multiple network elements. Some or all of the modules may be selected as needed to achieve the purpose of the solution of the embodiments. Persons of ordinary skill in the art can understand and implement the solution without any creative effort.

Those skilled in the art may further realize that the units and algorithm steps of each example described in connection with the embodiments disclosed herein can be implemented by electronic hardware, computer software, or a combination of both. In order to clearly illustrate the interchangeability of hardware and software, the modules and steps of each example have been described in general terms of functionality in the above description. Whether these functions are performed in hardware or software depends on the specific application and design constraints of the technical solution. Those skilled in the art may implement the described functionality in various manners for each specific application, while such implementations should not be considered to be beyond the scope of the present application.

The disclosed embodiments have described above, so that those skilled in the art can make or use the present application. Various modifications to these embodiments will be readily derived by those skilled in the art, and the generic principles defined herein may be practiced in other embodiments without departing from the spirit or scope of the invention. Thus, the present application is not intended to be limited to the embodiments shown herein but in accorded with the widest scope consistent with the principles and novel features disclosed herein.

## Claims

1. A control method, applied to a relay circuit comprising a controller, a relay, a controllable switch and a power supply, wherein the controllable switch is connected in series with a coil of the relay, the power supply supplies power to the coil of the relay, the controllable switch is controlled by the controller, and the method comprises:
receiving an operating parameter of the relay by the controller; and
adjusting a driving force applied to the relay, based on the operating parameter by the controller, to reduce a total loss of the relay, wherein the total loss of the relay is a sum of a conduction loss and a driving loss of the relay.

2. The control method according to claim 1, wherein
the relay circuit further comprises a parameter collection device for acquiring the operating parameter, the parameter collection device is connected to the controller, and the operating parameter of the relay comprises at least an ambient temperature at a contact of the relay or a current flowing through the contact of the relay.

3. The control method according to claim 2, wherein the adjusting the driving force applied to the relay comprises:
increasing the driving force applied to the relay when the current flowing through the contact or the ambient temperature at the contact increases, to reduce the total loss of the relay by reducing the conduction loss of the relay; and
decreasing the driving force applied to the relay when the current flowing through the contact or the ambient temperature at the contact decreases, to reduce the total loss of the relay by reducing the driving loss of the relay.

4. The control method according to claim 2 or 3, wherein the adjusting the driving force applied to the relay comprises:
controlling a duty cycle of a drive signal for driving the controllable switch using pulse width modulation, based on the operating parameter of the relay, to adjust the driving force applied to the relay.

5. The method according to claim 4, wherein the controlling the duty cycle of the drive signal comprises:
controlling the duty cycle of the drive signal based on a value of the operating parameter of the relay, to adjust the driving force applied to the relay.

6. The control method according to claim 4, wherein the operating parameter is the current flowing through the contact of the relay, and wherein the controlling the duty cycle of the drive signal comprises:
adjusting the duty cycle of the drive signal based on a waveform of the current flowing through the contact of the relay, to match a waveform of a current or voltage of the coil of the relay to the waveform of the current flowing through the contact of the relay.

7. The control method according to claim 4, wherein the controlling of the duty cycle of the drive signal comprises:
comparing the operating parameter with at least one threshold;
setting the drive signal to a first duty cycle, when the operating parameter of the relay is greater than the threshold; and
setting the drive signal to a second duty cycle, when the operating parameter of the relay is less than the threshold, wherein the first duty cycle is greater than the second duty cycle, and the driving force at the first duty cycle is strong by comparison with the second duty cycle.

8. The control method according to claim 5, wherein the controlling the duty cycle of the drive signal based on the value of the operating parameter comprises:
adjusting the duty cycle of the drive signal to increase a current or voltage of the coil of the relay, in response to an increase in the operating parameter; and
adjusting the duty cycle of the drive signal to decrease the current or voltage of the coil of the relay, in response to a decrease in the operating parameter.

9. The control method according to claim 8, wherein
the adjusting the duty cycle of the drive signal to increase the current or voltage of the coil of the relay comprises: adjusting the duty cycle of the drive signal to increase the current or voltage of the coil of the relay linearly in response to the increase in the operating parameter; and
the adjusting the duty cycle of the drive signal to decrease the current or voltage of the coil of the relay comprises: adjusting the duty cycle of the drive signal to decrease the current or voltage of the coil of the relay linearly in response to the decrease in the operating parameter.

10. The control method according to claim 2 or 3, wherein the power supply is an adjustable power supply controlled by the controller, and wherein the adjusting the driving force applied to the relay comprises:
changing a voltage of the adjustable power supply based on the operating parameter, to adjust the driving force applied to the relay.

11. The control method according to claim 10, wherein the changing the voltage of the adjustable power supply based on the operating parameter comprises:
increasing the voltage of the adjustable power supply to strengthen the driving force applied to the relay, in response to an increase in the operating parameter; and
decreasing the voltage of the adjustable power supply to weaken the driving force applied to the relay, in response to a decrease in the operating parameter.

12. The control method according to any one of claims 1 to 3, wherein the adjusting the driving force applied to the relay comprises:
regulating the driving force applied to the relay within a preset range, wherein an upper limit of the preset range does not exceed an upper limit allowed by the relay, and a lower limit of the preset range is not less than a lower limit sufficient for contacts of the relay attached.
